# EUROPÄISCHE PATENTANMELDUNG

(11) **EP 1 400 345 A1**
(43) Veröffentlichungstag der Anmeldung: **24.03.2004**
(21) Anmeldenummer: 02021355.9
(22) Anmeldetag: 23.09.2002
(51) Int. Cl.: B32B 15/08, B32B 27/22

(54) **Verfahren zur Herstellung eines Kunststoffproduktes**

(71) Anmelder: Heine, Götz, 87719 Mindelheim (DE)
(72) Erfinder: Heine, Götz, 87719 Mindelheim (DE)
(74) Vertreter: Heinze, Ekkehard, Dipl.-Phys. Dr.

(57) **Zusammenfassung**

Verfahren zur Herstellung eines geformten Kunststoffproduktes, das mindestens eine geschlossene funktionswesentliche Oberfläche mit einem Weichmacher enthaltenden Kunststoffmaterial aufweist, wobei die Kunststoffmaterial-Oberfläche nach der Formgebung im wesentlichen vollständig in einem VakuumBeschichtungsverfahren mit einer Metall-Dünnschicht, insbesondere aus Ti oder einer Ti-Legierung, bedeckt wird, welche als Weichmacher-Diffusionssperre wirkt.

## Beschreibung

Die Erfindung betrifft ein Verfahren zur Herstellung eines geformten Kunststoffproduktes nach dem Oberbegriff des Anspruchs 1 bzw. eines Textilproduktes mit Kunststofffaseranteilen nach dem Oberbegriff des Anspruchs 8.

Kunststoffmaterialien sind heute aus den verschiedensten Bereichen des täglichen Lebens nicht mehr wegzudenken und haben aufgrund überlegener Gebrauchseigenschaften und niedriger Kosten in vielen Anwendungen Naturprodukte sowie auch Glas- und Keramikerzeugnisse weitgehend verdrängt. In anderen Bereichen, beispielsweise bei der Herstellung von Textilien, wurden attraktive Kompromisslösungen gefunden, bei denen Kunststoffmaterialien zusammen mit natürlichen Materialien - also speziell etwa Kunststofffasern zusammen mit Wolle oder Baumwolle oder anderen Naturfasern - zu Produkten mit besonders vorteilhaften Eigenschaften verarbeitet werden.

Moderne Kunststoffmaterialien enthalten neben den polymeren Hauptkomponenten eine Reihe von Zuschlagstoffen, die der Verbesserung wesentlicher Eigenschaften dienen, etwa der Erhöhung der Widerstandsfähigkeit und Lebensdauer, speziell z.B. der UV-Beständigkeit, der Verringerung der Sprödigkeit und Einstellung der Elastizität, der Erzielung hydrophober Eigenschaften o.ä. Es versteht sich, dass derartige Additive zu Kunststoffmaterialien, die dem menschlichen Gebrauch dienen, auf ihre gesundheitliche Unbedenklichkeit geprüft werden und auch die fertigen Kunststoffmaterialien in aller Regel den Anforderungen des Gesundheits-, Arbeits- und Brandschutzes genügen.

Gleichwohl zeigen Kunststoffmaterialien im alltäglichen Gebrauch häufig Eigenschaften, die ihren Gebrauchswert spürbar verringern. Hierzu zählt etwa die Eigenschaft von Kunststoff-Trinkflaschen, darin aufbewahrtem Wasser schon nach relativ kurzer Zeit einen unangenehmen Beigeschmack zu geben - bis dahin, dass es praktisch kaum noch trinkbar ist. Bekannt sind auch die unangenehmen Ausdünstungen von Kunststofffasern in Textilien, wie etwa Möbelbezugsstoffen, im Neuzustand oder - sogar nach längerer Gebrauchsdauer - bei höheren Temperaturen. Ähnliche Ausdünstungen zeigen auch viele der für die Innenausstattung von Fahrzeugen, wie etwa Pkw, oder auch bei der Herstellung von Polstermöbeln sowie im Bereich des Bauwesens eingesetzten Kunststoffschäume.

Es ist bekannt, Kunststoffgegenstände durch Galvanisierung oder auch Aufwalzen mit einer metallischen Beschichtung zu versehen, um ihnen zumindest oberflächlich die Eigenschaften - insbesondere die ästhetische Anmutung - eines Metalls zu verleihen. Derart behandelte Kunststoff-Gebrauchsgegenstände sind jedermann aus dem täglichen Gebrauch bekannt.

Ferner ist es seit langem bekannt, Kunststofffolien für dekorative Zwecke oder zur Herstellung von Lebensmittelverpackungen durch einen Hochvakuumbeschichtungsprozess mit einer dünnen Metallschicht, speziell Aluminiumschicht, zu versehen. Sofern hiermit nicht ebenfalls ein ästhetischer bzw. gestalterischer Zweck verfolgt wird, sollen derartige Folien - etwa im Einsatz als Verpackungsbeutel - die Aromastabilität von Lebensmitteln in der entsprechenden Verpackung verbessern, also der Kunststofffolie bezüglich des zu verpackenden Gutes bis zu einem gewissen Grade die Eigenschaften einer Metallfolio (Al-Folie) verleihen. Mit derartigen Verfahren befasst sich ein umfangreicher Stand der Technik; es sei hier rein beispielhaft verwiesen auf die jüngere DE 100 39 366 A1 oder die DE 198 13 271 A1.

Aus der DE 43 12 926 A1 ist ein Verfahren zur Herstellung eines Metall-Kunststoff-Verbundmaterials bekannt, bei dem die Metalloberfläche und wahlweise zusätzlich auch die Kunststoffoberfläche mit gepulster Laserstrahlung abgerastert wird. Dieses Verfahren soll die Herstellung von Verbundfolien mit verschiedenen Metallen, u.a. Al, Ti, Ni und Edelmetallen, ermöglichen.

Aus der DE 100 57 605 A1 ist ein Verfahren zur Bildung einer durch hohe mechanische Festigkeit gekennzeichneten Oberflächenbeschichtung bekannt geworden, welches den Gasphasenbeschichtungsverfahren (CVD-Verfahren) zuzurechnen ist. Die Autoren ziehen sowohl eine plasmafreie CVD als auch eine plasma-unterstützte CVD (PACVD) oder Plasma-CVD (PCVD) in Betracht. Als Basismaterial dienen hier allerdings insbesondere Metalllegierungen, Sinterhartmetalle und Keramiken sowie Verbunde aus diesen. Mit einem solchen Verfahren befasst sich auch die WO 00/22187, wobei hier speziell die Aufbringung von titanhaltigen Hartstoffschichten auf ein Substrat beschrieben wird.

Aus der EP 0 792 382 B1 ist eine Vorrichtung zur Vakuumbeschichtung von Schüttgut, u.a. auch aus Kunststoffmaterialien bestehend, bekannt. Basis sind auch hier die erwähnten CVD-Verfahren oder die physikalische Gasphasenabscheidung (PVD).

Das Vorsehen von dünnen Schichten aus Titanverbindungen - speziell auch im Hochvakuum aufgebrachten Schichten - ist aus einer Reihe von Druckschriften auch speziell für medizinische Instrumente bekannt geworden; vgl. etwa die DE 42 12 053 C1 oder DE 198 01 535 A1. Diese Schichten dienen neben der Erhöhung der Oberflächenhärte ggf. auch der besseren Trennung von Instrumenteilen an Gleitflächen oder der Realisierung einer farblichen Kennzeichnung.

Beispielsweise aus der DE 34 36 097 C2, der DE 198 23 203 A1 oder der DE 200 03 073 U1 sind auch Textilien mit metallischer Dünnschicht bekannt geworden. Hierbei beschreibt die erstgenannte Druckschrift allgemein ein geeignetes Sputter-Verfahren, die zweite der Druckschriften die Herstellung eines beschichteten flexiblen Bandmaterials, u.a. zur dekorativen und/oder funktionellen Ausrüstung von Bekleidungsteilen, und die letztgenannte Druckschrift einen auf der Außenseite strahlungsreflektierend mit Titan beschichteten Schutzanzug.

Aus der DE 199 45 299 A1 ist ein Plasmabeschichtungsverfahren zur Beschichtung dreidimensionaler Kunststoffsubstrate mit einer metallhaltigen Beschichtung auf der Kunststoffoberfläche bekannt geworden, welches insbesondere zur Beschichtung implantierbarer textiler Prothesen oder Gefäßprothesen geeignet ist, da es mit relativ niedrigen Substrattemperaturen auskommt und gleichwohl die Beschichtung von Substraten mit Hinterschneidungen und/oder von außen zugänglichen Hohlräumen ermöglicht.

In der US-2002-0081407-A1 des Anmelders wird ein Bekleidungselement mit einer titanhaltigen Beschichtung auf der dem Körper zugewandten Oberfläche zur Erhöhung der physischen Leistungsfähigkeit und des physischen Wohlbefindens des Trägers beschrieben.

Der Erfindung liegt die Aufgabe zugrunde, ein Verfahren zur Herstellung verbesserter Kunststoffprodukte anzugeben, mit dem deren jeweils wesentlichen Gebrauchseigenschaften verbessert werden können und insbesondere Gebrauchswerteinschränkungen der oben erwähnten Art begegnet werden kann.

Diese Aufgabe wird, in relativ unabhängigen Ausprägungen des Erfindungsgedankens, durch ein Verfahren mit den Merkmalen des Anspruchs 1 bzw. des Anspruchs 8 gelöst. Zweckmäßige Fortbildungen des Erfindungsgedankens sind in den abhängigen Ansprüchen verankert.

Die Erfindung schließt den grundlegenden Gedanken ein, eine Kunststoffoberfläche eines mindestens teilweise aus Kunststoff bestehenden Produktes mit einer Diffusionssperre für Inhaltsstoffe zu versehen, die, wenn sie auf der jeweiligen Oberfläche vorliegen, eine Verschlechterung relevanter Gebrauchseigenschaften bewirken. Es geht hier insbesondere um Weichmacher oder ähnlich wirkende Additive, die von der Oberfläche des Kunststoffgegenstandes aus in die Atmosphäre oder ein mit der Oberfläche in Kontakt kommendes Lebensmittel wandern können und dort Geruchsbelästigungen, Geschmacksbeeinträchtigungen oder andere nachteilige Wirkungen hervorrufen. Des weiteren wird durch die erwähnte Diffusionssperre auch einer durch die Ansammlung derartiger Stoffe auf der Oberfläche ggf. eintretenden Verschlechterung relevanter physikalischer Parameter der Oberfläche, wie etwa der Oberflächenspannung oder Hydrophobie o.ä., entgegengewirkt.

Weiterhin gehört zur Erfindung der Gedanke, eine derartige Diffusionssperre durch eine bezüglich der relevanten Gebrauchswerteigenschaften praktisch neutrale Metallschicht zu realisieren. Es kann sich bei dem Metall insbesondere um das in bewährter Weise biokompatible Titan, je nach Anwendungsfall aber auch um Aluminium, Nickel, Chrom oder eine Legierung aus diesen, Gold oder Platin oder eine Legierung aus diesen oder auch ein anderes geeignetes Metall handeln.

Schließlich umfasst die Erfindung den Gedanken, die Diffusionssperre als Dünnschicht auf an sich bekannte Weise in einem Vakuum-Beschichtungsverfahren zu erzeugen und damit eine hervorragende Wirkung mit niedrigem Metallverbrauch und hoher mechanischer Beständigkeit der aufgebrachten Schicht zu verbinden. Die Dicke der Metallschicht liegt grundsätzlich im Bereich zwischen etwa 10 nm und wenigen µm und wird im konkreten Anwendungsfall in Abhängigkeit von Art und Konzentration der Inhaltsstoffe eines Kunststoffes festgelegt, für die Metallschicht als Diffusionssperre wirken soll. Bei geringen Schichtdicken ist die Metallschicht (auch auf transparenten Kunststoffgegenständen) praktisch unsichtbar, so dass keine wesentliche Veränderung des äußeren Erscheinungsbildes des entsprechenden Kunststoffproduktes zu befürchten ist. Andererseits lässt sich durch höhere Schichtdicken auch bewusst eine "metallische" Anmutung als Nebeneffekt der Beschichtung erzielen.

In einer bevorzugten Verfahrensführung wird die Metall-Dünnschicht durch eine chemische Gasphasenabscheidung, insbesondere mittels PACVD, gebildet. Als besonders geeignet erscheint aus derzeitiger Sicht ein (ggf. mehrschrittiges) Plasmaverfahren, mit dem sich mit niedrigen Prozesstemperaturen die Beschichtung von Hinterschneidungen ebenso realisieren lässt wie die Innenbeschichtung von Kunststoffgegenständen, etwa Kunststoffbehältern. Es gibt jedoch auch (wie nachfolgend genauer ausgeführt) Kunststoffprodukte, bei denen ein einfacheres CVD- oder PVD-Verfahren mit Vorteil angewandt werden kann, weil dort Kunststoffträger mit relativ hoher Temperaturbeständigkeit vorliegen und/oder lediglich eine Außenflächen-Beschichtung erforderlich ist.

Die für einen konkreten Anwendungsfall geeignete Konstellation von Parametern des Beschichtungsprozesses lässt sich für den Fachmann anhand der Eigenschaften des jeweiligen Kunststoffgegenstandes anhand seines Fachwissens leicht ermitteln, so dass genauere Angaben hierzu an dieser Stelle nicht erforderlich sind.

In einer ersten Anwendung von besonderer praktischer Bedeutung wird die Innenoberfläche eines Lebensmittelbehälters, insbesondere einer Getränkeflasche, einer Aufbewahrungsbox oder eines Geschirrteiles, mit der Metall-Dünnschicht bedeckt. Hierdurch lässt sich praktisch jegliche Geschmacksbeeinflussung durch das Kunststoffmaterial des Behälters vermeiden und der Inhalt - sogar reines Wasser - lange ohne weiteres trinkbar halten.

Eine weitere wichtige Anwendung wird derzeit darin gesehen, dass die dem Innenraum zugewandte Oberfläche eines Innenverkleidungselementes eines Verkehrsmittels, insbesondere Pkw, Busses, Eisenbahnwagons oder Flugzeuges, mit der Metall-Dünnschicht bedeckt wird. Hierdurch kann dem oben erwähnten "Ausdünsten" von Inhaltsstoffen des jeweiligen Kunststoffmaterials - insbesondere von Kunststoffschäumen - effektiv entgegengewirkt werden. Dies stellt eine wesentliche Gebrauchswertsteigerung bei den entsprechenden Fahrzeugen dar, wobei sich die mit der Erfindung erzielte Wirkung besonders positiv bei der Besichtigung, probeweisen Benutzung und anfänglichen Benutzung neuer Fahrzeuge bemerkbar macht und wesentlich zur Ausbildung von Kaufbereitschaft beitragen dürfte.

In einer weiteren wesentlichen Anwendung der Erfindung ist vorgesehen, dass mindestens eine Außenseite eines Sportartikels, insbesondere die Gleitfläche eines Ski, Snowboards oder Surfbretts oder die Außenhaut eines Sportwagens, Sportflugzeuges oder Sportbootes, mit der Metall-Dünnschicht bedeckt wird. Hiermit lässt sich im - insbesondere wettkampfmäßigen - Gebrauch bei geeigneter Wahl des Beschichtungsmetalls und der Schichtdicke eine u.U. deutliche Verbesserung des Gleitverhaltens erreichen. Bekanntermaßen ist das Auftreten einer solchen Wirkung im Wettkampfbereich aber auch ein wesentliches Kaufargument für den nicht wettkampforientierten Sportler, so dass eine breite Nutzung auch im Consumer-Bereich zu erwarten ist.

In einer weiteren wichtigen Ausgestaltung des vorgeschlagenen Verfahrens ist vorgesehen, dass die mit Körperflüssigkeit oder der Haut direkt in Kontakt kommende Oberfläche eines nicht dauerhaft implantierbaren medizinischen Produktes, insbesondere einer Schiene oder Orthese, einer Kontaktlinse oder einer Verhütungs-Spirale, mit der Metall-Dünnschicht bedeckt wird. Hiermit lassen sich an sich bekannte, in der Vergangenheit aber mehr oder weniger hingenommene Verträglichkeitsprobleme bei derartigen Produkten voraussichtlich für breite Patientenkreise beseitigen, ohne dass die Kosten für die entsprechenden Produkte sich über Gebühr erhöhen würden. Als Beschichtungsmaterial dürften sich hier insbesondere Ti und Ti-Legierungen eignen.

Im Bereich der Erfindung liegt es weiterhin, dass sämtliche zugänglichen Oberflächen eines Kinderspielzeugs oder Babyartikels, insbesondere Schnullers, Beißringes oder dergleichen, mit der Metall-Dünnschicht bedeckt werden. Hierbei ist von besonderer Bedeutung, dass einerseits Kunststoff-Spielzeuge und -Babyartikel häufig aus Weichkunststoffen mit einem besonders hohen Weichmacheranteil hergestellt werden und andererseits Babys und Kleinkinder als Nutzer derartiger Gegenstände vielfach besonders empfindlich gegenüber derartigen chemischen Zusätzen sind - auch wenn diese nach amtlichen Prüfrichtlinien nicht als gesundheitsgefährdend einzustufen sind.

Was die Nutzung des vorgeschlagenen Verfahrens für Textilprodukte angeht, so wird eine erste bedeutungsvolle Anwendung darin gesehen, dass die Außenseite eines Sportbekleidungsstückes, insbesondere eines Badeanzugs oder einer Badhose, eines Taucheranzuges, eines Sportschuhs, einer Sporthose, eines Sporttrikots oder eines Lauf- oder Skianzuges, oder die im fertigen Zustand eine solche Außenseite bildende Oberfläche einer Textilbahn mit der Metall-Dünnschicht bedeckt wird. Auch hier kommt dann die Verbesserung der Gleiteigenschaften aufgrund der Unterbindung von Beeinträchtigungen der physikalischen Oberflächenparameter des entsprechenden Textilgutes zum Tragen.

Eine weitere wichtige Anwendung besteht darin, dass die Außenseite eines Möbeloder Fahrzeugsitzbezuges oder die im fertigen Zustand eine solche Außenseite bildende Oberfläche einer Textilbahn mit der Metall-Dünnschicht bedeckt wird. Hiermit wird ein Beitrag zur oben bereits erläuterten Unterbindung von unangenehmen Ausdünstungen in einen Innenraum geleistet, in dem sich Menschen über längere Zeit aufhalten.

Für die Beschichtung von Textilprodukten ist eine erste Verfahrensführung derart vorgesehen, dass die Metall-Dünnschicht auf eine Oberfläche einer durchlaufenden Textilbahn zur Herstellung des Textilproduktes aufgebracht wird. Alternativ hierzu wird die Metall-Dünnschicht auf das fertig konfektionierte Textilprodukt aufgebracht. Mit diesen Alternativen lässt sich - je nach Größe und Beschaffenheit des entsprechenden Textilproduktes - eine wirtschaftlich optimierte Verfahrensgestaltung finden.

Die Erfindung ist indes nicht auf die oben beschriebenen Anwendungen und Verfahrensaspekte beschränkt, sondern ebenso in einer Vielzahl von Abwandlungen ausführbar, die im Rahmen fachgemäßen Handelns liegen.

## Patentansprüche

1. Verfahren zur Herstellung eines geformten Kunststoffproduktes, das mindestens eine geschlossene funktionswesentliche Oberfläche mit einem Weichmacher enthaltenden Kunststoffmaterial aufweist,
**dadurch gekennzeichnet, dass**
die Kunststoffmaterial-Oberfläche nach der Formgebung im wesentlichen vollständig in einem Vakuum-Beschichtungsverfahren mit einer Metall-Dünnschicht, insbesondere aus Ti oder einer Ti-Legierung, bedeckt wird, welche als Weichmacher-Diffusionssperre wirkt.

2. Kunststoffprodukt nach Anspruch 1,
**dadurch gekennzeichnet, dass**
die Metall-Dünnschicht durch eine chemische Gasphasenabscheidung, insbesondere mittels PACVD, gebildet wird.

3. Verfahren nach Anspruch 1 oder 2,
**dadurch gekennzeichnet, dass**
die Innenoberfläche eines Lebensmittelbehälters, insbesondere einer Getränkeflasche, einer Aufbewahrungsbox oder eines Geschirrteiles, mit der Metall-Dünnschicht bedeckt wird.

4. Verfahren nach Anspruch 1 oder 2,
**dadurch gekennzeichnet, dass**
die dem Innenraum zugewandte Oberfläche eines Innenverkleidungselementes eines Verkehrsmittels, insbesondere Pkw, Busses, Eisenbahnwagons oder Flugzeuges, mit der Metall-Dünnschicht bedeckt wird.

5. Verfahren nach Anspruch 1 oder 2,
**dadurch gekennzeichnet, dass**
mindestens eine Außenseite eines Sportartikels, insbesondere die Gleitfläche eines Ski, Snowboards oder Surfbretts oder die Außenhaut eines Sportwagens, Sportflugzeuges oder Sportbootes, mit der Metall-Dünnschicht bedeckt wird.

6. Verfahren nach Anspruch 1 oder 2,
**dadurch gekennzeichnet, dass**
die mit Körperflüssigkeit oder der Haut direkt in Kontakt kommende Oberfläche eines nicht dauerhaft implantierbaren medizinischen Produktes, insbesondere einer Schiene oder Orthese, einer Kontaktlinse oder einer Verhütungs-Spirale, mit der Metall-Dünnschicht bedeckt wird.

7. Verfahren nach Anspruch 1 oder 2,
**dadurch gekennzeichnet, dass**
sämtliche zugänglichen Oberflächen eines Kinderspielzeugs oder Babyartikels, insbesondere Schnullers, Beißringes oder dergleichen, mit der Metall-Dünnschicht bedeckt werden.

8. Verfahren zur Herstellung eines Textilproduktes, welches mindestens einen Anteil einer einen Weichmacher enthaltenden Kunststofffaser aufweist,
**dadurch gekennzeichnet, dass**
mindestens eine Außenoberfläche des Textilproduktes in einem Vakuum-Beschichtungsverfahren im wesentlichen vollständig mit einer Metall-Dünnschicht, insbesondere aus Ti oder einer Ti-Legierung, bedeckt wird, welche als Weichmacher-Diffusionssperre wirkt.

9. Verfahren nach Anspruch 8,
**dadurch gekennzeichnet, dass**
die Metall-Dünnschicht auf eine Oberfläche einer durchlaufenden Textilbahn zur Herstellung des Textilproduktes aufgebracht wird.

10. Verfahren nach Anspruch 8,
**dadurch gekennzeichnet, dass**
die Metall-Dünnschicht auf das fertig konfektionierte Textilprodukt aufgebracht wird.

11. Verfahren nach einem der Ansprüche 8 bis 10,
**dadurch gekennzeichnet, dass**
die Außenseite eines Sportbekleidungsstückes, insbesondere eines Badeanzugs oder einer Badhose, eines Taucheranzuges, eines Sportschuhs, einer Sporthose, eines Sporttrikots oder eines Lauf- oder Skianzuges, oder die im fertigen Zustand eine solche Außenseite bildende Oberfläche einer Textilbahn mit der Metall-Dünnschicht bedeckt wird.

12. Verfahren nach einem der Ansprüche 8 bis 10,
**dadurch gekennzeichnet, dass**
die Außenseite eines Möbel- oder Fahrzeugsitzbezuges oder die im fertigen Zustand eine solche Außenseite bildende Oberfläche einer Textilbahn mit der Metall-Dünnschicht bedeckt wird.
